Europäisches Patentamt

(19) European Patent Office

Office européen des brevets

(11) Publication number : **0 438 260 A2**

# (12) EUROPEAN PATENT APPLICATION

(21) Application number : 91300264.8

(51) Int. Cl.⁵ : **H03L 7/199**

(22) Date of filing : 15.01.91

(30) Priority : 19.01.90 US 467829

(43) Date of publication of application :
24.07.91 Bulletin 91/30

(84) Designated Contracting States :
AT BE CH DE DK ES FR GB GR IT LI LU NL SE

(71) Applicant : MOTOROLA, INC.
1303 East Algonquin Road
Schaumburg, IL 60196 (US)

(72) Inventor : Baraban, James P.
1007 Southbridge Lane
Schaumburg, Illinois 60194 (US)
Inventor : Moller, Paul J.
126 Heather Lane
Streamwood, Illinois 60107 (US)
Inventor : Skutta, Frank R.
1323 Bedford
Palatine, Illinois 60067 (US)

(74) Representative : Dunlop, Hugh Christopher et
al
Motorola European Intellectual Property
Operations Jays Close Viables Industrial
Estate
Basingstoke, Hampshire RG22 4PD (GB)

(54) Capacitor precharge for reduced synthesizer lock time.

(57) A method and process for reducing the frequency lock-on time required for a radiotelephone transitioning from a standby mode to a normal operation mode. The present invention comprises a microphone (101) coupled to a transmit synthesizer (104) through audio circuitry (102), a reference oscillator (103), and a transistor switch (109) controlled by a processing device (110). The transmit synthesizer (104) is comprised of a phase detector (105) coupled to a loop filter (106) that is coupled to a voltage controlled oscillator (VCO) (107). The output of the VCO (107), which is also the output of the present invention, is fed back through a divide by N (108) to the phase detector. The microcomputer (110), in the standby mode, periodically switches on power to the transmit synthesizer (104), keeping a capacitor in the loop filter (106) charged and thereby maintaining the voltage applied to the VCO (107). This voltage determines the frequency of the signal produced by the VCO (107). If this voltage is kept at the level used during normal operation, when the radiotelephone goes from standby to normal, this voltage will be close to the proper level.

EP 0 438 260 A2

# FIG.1

# CAPACITOR PRECHARGE FOR REDUCED SYNTHESIZER LOCK TIME

## Field of the Invention

The present invention relates generally to the communications field and particularly to cellular radiotelephone field.

## Background of the Invention

The cellular radiotelephone system, using multiple low power transceivers covering a geographical area, allows mobile and portable radiotelephones to remain in contact with the landline telephone system. The mobile radiotelephones are typically powered by a car's electrical system while the portable is typically powered by a battery attached to the radiotelephone. The mobile radiotelephone, therefore, does not have to conserve power due to its almost limitless power source. The portable's power, however, is limited by the battery and must therefore conserve power.

One method used to conserve battery power is for the radiotelephone control circuitry to shut off power to certain parts of the radiotelephone. Typically, the transmitter section of a radiotelephone draws a substantial amount of power and is shut down for power conservation. The transmitter synthesizer, which is typically part of the transmitter, generates a fixed frequency by using a steering line voltage to lock the transmitter synthesizer at the desired frequency. This synthesizer frequency is mixed with another variable frequency to generate the transmit frequencies.

With the steering line voltage removed. the synthesizer loses the frequency it was locked onto. The steering line voltage typically will remain for a short time after power is removed due to capacitor discharge. When power is returned to the synthesizer, it must relock the frequency by increasing the steering line voltage back to its original level. The time taken to return the synthesizer to the original frequency must meet a minimum time called for in international cellular telephone specifications of 6.5 milliseconds. There is a resulting need for a method and apparatus for keeping the steering line voltage at a proper level for a desired frequency during power conservation periods.

## Summary of the Invention

According to the invention, there is provided a method and apparatus as defined in the claims.

The present invention has the advantage of decreasing the frequency lock-on time required for a radiotelephone transitioning from a standby mode to a normal mode of operation. In a preferred embodiment there is provided a microphone coupled to a transmit synthesizer through audio circuitry, a reference oscillator, and a transistor switch controlled by a processing device ; the processing device being a microcomputer in the preferred embodiment. The transmit synthesizer is comprised of a phase detector coupled to a loop filter that is coupled to a voltage controlled oscillator (VCO). The output of the VCO, which is also the output of the present invention, is fed back through a divide by N to the phase detector.

The microcomputer, in the standby mode, periodically switches on power to the transmit synthesizer. In the preferred embodiment, the power is turned on for fifty milliseconds every minute. This periodic power application will keep a capacitor in the loop filter charged which in turn will maintain the voltage level applied to the VCO. When the radiotelephone transitions from the standby mode to the normal mode, the voltage to the VCO will be essentially the proper voltage for the desired frequency. This will reduce the time required to reach the desired voltage for the desired frequency.

## Brief Description of the Drawings

Figure 1 illustrates a block diagram of a preferred embodiment of present invention ; and
Figure 2 illustrates a flow chart of the preferred embodiment.

## Detailed Description of the Preferred Embodiment

The preferred embodiment of the invention encompasses a process and apparatus that provides a portable radiotelephone or other battery powered radio with quick synthesizer lock-on capability. By keeping the voltage to the voltage controlled oscillator up with short power applications in the standby mode, the transmitter synthesizer can be locked on quicker when it is returned to the normal mode.

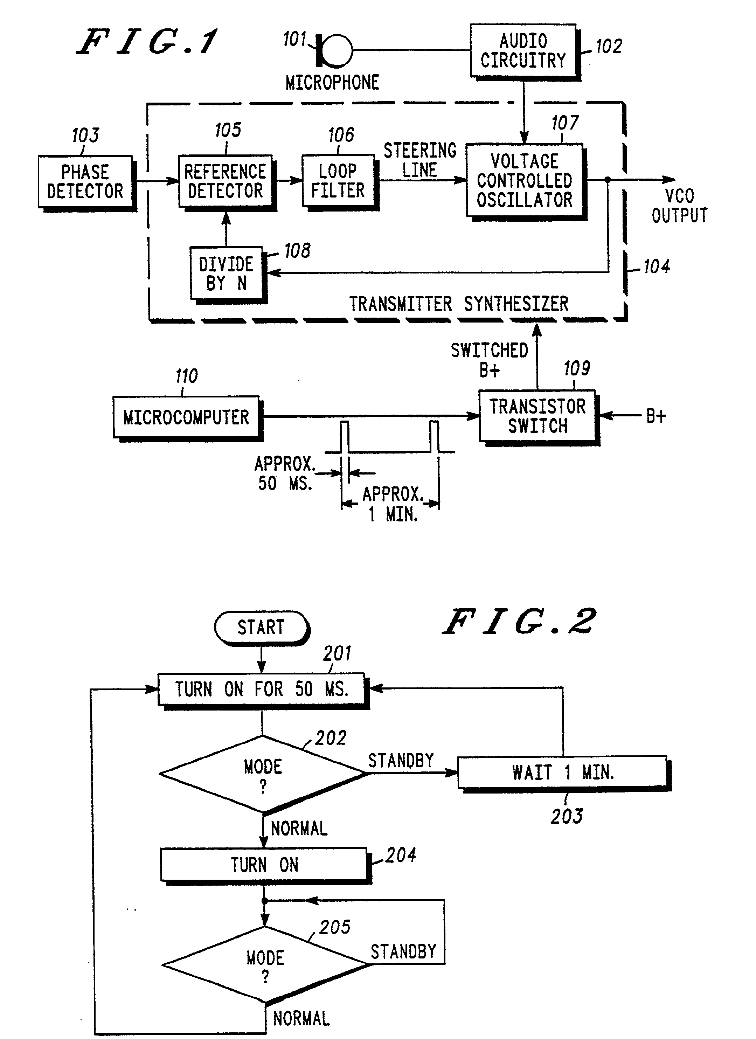

The apparatus, as illustrated in Figure 1, comprises a microphone (101) coupled to a transmit synthesizer (104) through audio circuitry (102), a reference oscillator (103), and a transistor switch (109) controlled by a processing device (110) ; the processing device (110) being a microcomputer in the preferred embodiment. The transmit synthesizer (104), which is modulated by the incoming audio signal, is modulated in the range of human speech, typically, 300 Hz to 3500 Hz. The synthesizer (104) is comprised of a phase detector (105) coupled to a loop filter (106) that is coupled to a voltage controlled oscillator (VCO) (107). The output of the VCO (107), which is also the output of the present invention, is fed back through a divide by N (108) to the phase detector (105). The output of the present invention is a signal of a fixed frequency that is mixed with a signal with a variable frequency to generate the transmit frequencies for the radiotelephone device.

The transmit synthesizer (104) receives a signal from the reference oscillator (103). This signal is input to the phase detector (105) that compares it with the phase of the feedback signal from the VCO (107) output. The output of the phase detector (105) will be a voltage level based on the phase error detected between the reference signal and the feedback signal. The output of the phase detector (105) is filtered by the loop filter (106) to remove the low frequency components before it drives the VCO (107). The steering line voltage applied to the VCO (107) determines the frequency of the transmit synthesizer (104). When the transmit synthesizer (104) reaches the desired frequency, this voltage will be at the proper level since the phase error between the feedback signal and the reference signal will be constant. The steering line voltage must be maintained at that level to keep the VCO (107) in lock, thereby producing the desired frequency. The divide by N (108) divides the signal frequency down to a level that can be handled by the phase detector (105).

During the normal mode of operation, the microcomputer (110) turns on the switch (109) coupled to the transmit synthesizer (104). This applies power to the synthesizer (104) continuously. The normal mode of operation in a radiotelephone occurs when the radiotelephone is being used for communicating. When the radiotelephone is no longer communicating, a portable radiotelephone will need to conserve power and switches to the standby mode of operation. In this mode, power to all but the controlling circuits is turned off, including the transmit synthesizer (104). When the power to the synthesizer (104) is removed, the steering line voltage will begin to drop. A capacitor in the loop filter (106), however, will slow the voltage decay.

This steering line voltage is maintained while the radiotelephone is in the standby mode. The microcomputer (110), while in the standby mode, periodically switches power to the transmit synthesizer (104). In the preferred embodiment, power is switched to the transmit synthesizer (104) for fifty milliseconds every one minute. This is adequate to keep the steering line voltage up so that when the radiotelephone returns to the normal mode, the steering line voltage will be close to the proper voltage for the desired frequency output.

Figure 2 shows a flow chart of the process of the preferred embodiment. The transmit synthesizer is initially powered up for fifty milliseconds (201); the mode is then checked (202). If the standby mode is called for, a one minute delay occurs (203) before the synthesizer is again powered for fifty milliseconds (201). This continues until the normal mode is needed. In the normal mode synthesizer is then turned on continuously (204) until the standby mode is again required (205), repeating the above procedure.

In summary, a method and apparatus has been shown that will reduce the frequency lock-on time required for a radiotelephone transitioning from a standby mode to normal power operation. This time is approximately 5.5 milliseconds using the present invention, which is within the specification time of 6.5 milliseconds. Without the present invention, a typical lock time is 25 - 30 milliseconds.

## Claims

1. A method for substantially maintaining a normal mode electrical state of a frequency control signal of a modulatable frequency synthesizer during a standby mode, the steps comprising :

   a) switching power to the modulatable frequency synthesizer during the normal mode ; and

   b) periodically switching power to the modulatable frequency synthesizer during the standby mode for a predetermined time ; whereby, the modulatable frequency synthesizer turns on and locks within a time interval less than a predetermined maximum lock time interval.

2. The method of claim 1 wherein the predetermined time is at least the lock time interval of the modulatable frequency synthesizer.

3. A modulatable frequency synthesizer, having a normal mode and a standby mode, for generating a modulated radio signal having a predetermined frequency, comprising :

   a) means for producing a modulation signal having a predetermined frequency range ;

   b) a reference oscillator ;

   c) phase locked loop means coupled to the reference oscillator and modulation signal ;

   d) control means for producing a control signal ; and

   e) switching means for switchably coupling power to the phase locked loop means in response to the control signal ;

   whereby, the switching means continuously couples power to the phase locked loop means during the normal mode and periodically couples power to the phase locked loop means for a predetermined time during the standby mode.

4. The modulatable frequency synthesizer of claim 3 wherein the predetermined frequency range is substantially within the range of human speech.

5. The modulatable frequency synthesizer of claim 3 wherein, in the standby mode, the power is coupled to the phase locked loop every one minute and the predetermined time is fifty milliseconds.

# FIG.1

101 MICROPHONE

AUDIO CIRCUITRY 102

103 PHASE DETECTOR

105 REFERENCE DETECTOR

106 LOOP FILTER

STEERING LINE

107 VOLTAGE CONTROLLED OSCILLATOR

VCO OUTPUT

108 DIVIDE BY N

104

TRANSMITTER SYNTHESIZER

SWITCHED B+

110 MICROCOMPUTER

109 TRANSISTOR SWITCH

B+

APPROX. 50 MS.

APPROX. 1 MIN.

# FIG.2

START

TURN ON FOR 50 MS. 201

MODE ? 202

STANDBY

WAIT 1 MIN. 203

NORMAL

TURN ON 204

MODE ? 205

STANDBY

NORMAL

6